# EUROPEAN PATENT APPLICATION

(11) **EP 2 500 954 A1**
(43) Date of publication of application: **19.09.2012**
(21) Application number: 10829809.2
(22) Date of filing: 15.10.2010
(51) Int. Cl.: H01L 33/48

(54) **SUBSTRATE FOR MOUNTING LIGHT-EMITTING ELEMENT AND METHOD FOR PRODUCING SAME**

(30) Priority: 12.11.2009 JP 2009259159
(71) Applicant: Denki Kagaku Kogyo Kabushiki Kaisha, Tokyo 103-8338 (JP)
(72) Inventor: YOSHIMURA,Eiji, Okaya-shi Nagano 394-0004 (JP)
(74) Representative: Sajda, Wolf E.
(86) International application number: PCT/JP2010/068152
(87) International publication number: WO 2011/058849

(57) **Abstract**

Disclosed is a method for producing a substrate for mounting a light-emitting element (30), whereby a substrate for mounting a light-emitting element (30) such that power can be supplied via a columnar metal body even if the side surfaces of the columnar metal body do not have pads can be produced by means of a low-cost and an easy step that does not involve lamination of a metal foil, plating, or the like. Further disclosed are a substrate for mounting a light-emitting element and a light-emitting element package. The substrate for mounting a light-emitting element (30) is provided with: at least two columnar metal bodies (14a-14c); at least two electrodes (10a-10b) that are provided on the rear surface side of the columnar metal bodies (14a-14c) so as to be conductive therewith; and an insulating layer (16) that exposes the upper surface of the columnar metal bodies (14a-14c). The sides of the columnar metal bodies do not have pads.

## Description

### TECHNICAL FIELD

The present invention relates to a method for producing a substrate for mounting a light-emitting element used for mounting a light-emitting element such as a light-emitting diode chip on a surface of a substrate and to a substrate for mounting a light-emitting element. Such a substrate for mounting a light-emitting element is particularly useful as a substrate of a light-emitting element package used in an illumination device.

### BACKGROUND ART

From the past, a substrate for mounting a light-emitting element is known in which a metal bump is formed via a protective metal layer on an upper surface of a metal substrate; an insulating resin layer having the same height as the height of the metal bump is formed around this metal bump; a heat-dissipating pattern on the upper surface of the metal bump and a power-feeding pattern on the upper surface of the insulating resin layer are formed simultaneously by plating; and a light-emitting element is made mountable on the upper surface of the metal bump via the heat-dissipating pattern (See the Patent Document 1).
Further, as a method for producing such a substrate for mounting a light-emitting element, the following method is known. As shown in FIG. 7(b) of Patent Document 1, a copper foil 23 provided with resin is heated and pressed on a metal substrate on which a metal bump 22b has been formed, so as to form a projection at a position corresponding to the metal bump 22b.
Subsequently, the bump is removed by grinding or polishing, so as to expose the metal bump 22b. Subsequently, after the metal bump 22b has been exposed, copper plating is carried out on the entire surface, and a power-feeding pattern is formed by etching. Also, a power-feeding pattern is formed by etching the copper foil 23a as well.

### PRIOR ART DOCUMENTS

### PATENT DOCUMENTS

Patent Document 1:
   Japanese Patent Application Laid-Open JPA-2005-167086

### SUMMARY OF THE INVENTION

### PROBLEMS TO BE SOLVED BY THE INVENTION

However, as described above, it is cumbersome to remove the bump by grinding or polishing to expose the metal bump 22b, to form the power-feeding pattern by etching after performing copper plating on the entire surface, and to form the power-feeding pattern by etching the copper foil 23, so that an improvement has been desired partly due to the demand for lowering the costs.

Also, in producing a light-emitting element package, it was soften employed that a white resist layer is formed on the substrate surface on the side of mounting the light-emitting element, and the light-emitting element is sealed with a light-transmitting resin after mounting the light-emitting element.
In that case, with respect to the substrate for mounting a light-emitting element in which the power-feeding pattern is formed on the surface, there is an undulation on the surface of the substrate, thereby raising a problem in that air is a liable to remain in the recess, while forming the white resist layer or the light-transmitting resin.

Therefore, an object of the present invention is to provide a method for producing a substrate for mounting a light-emitting element, whereby a substrate for mounting a light-emitting element such that power can be supplied via a metal bump even if the surfaces of the metal bump do not have pads can be produced by means of a low-cost and easy step that does not involve lamination of a metal foil, plating, or the like.
Further, an object is to provide a substrate for mounting a light-emitting element obtained by such a production method and a light-emitting element package using the substrate for mounting a light-emitting element. Preferably, an object is to provide a substrate for mounting a light-emitting element in which the surfaces on the side of mounting the light-emitting element are flat.

### SOLUTIONS TO THE PROBLEM

The aforementioned object can be achieved by the present invention such as will be described below.

A method for producing a substrate for mounting a light-emitting element of the present invention is characterized by comprising:
- a step of forming an insulating layer on a metal plate provided with a plurality of metal bumps to obtain a laminate body in which an upper surface of the metal bumps is exposed from the insulating layer;
- a step of dividing the metal plate into a plurality of parts to form electrodes that are conductive with the metal bumps; and
- a step of cutting the obtained laminate body to obtain a plurality of substrates having two or more metal bumps.

Since the production method of the present invention has the step of dividing the metal plate provided with the metal bumps into a plurality of parts to form electrodes that are conductive with the metal bumps and the step of cutting this to obtain a substrate having two or more metal bumps, power can be supplied to the light-emitting element via the metal bumps of the obtained substrate even if the surfaces of the metal bumps do not have pads.
Also, the heat generated in the light-emitting element can be efficiently dissipated to the rear surface side via the metal bumps. Therefore, there is no need to perform lamination of a metal foil, plating, or the like for forming the power-feeding pattern as in the prior art, so that costs can be reduced because less amount of source materials is needed, and also the production step will be extremely easy.
As a result of this, a substrate for mounting a light-emitting element such that power can be supplied via a metal bump even if the surfaces of the metal bump do not have pads can be produced by means of a low-cost and easy step that does not involve lamination of a metal foil, plating, or the like.

Also, it is preferable that the step of dividing the metal plate into a plurality of parts is carried out by etching. By this step, it is possible to form a pattern of electrodes or pads by etching, so that the metal plate can be formed to have an electrode shape or a pad shape suitable for solder connection or wire connection by an easy method.

It is preferable that the substrate for mounting a light-emitting element is a substrate for a light-emitting element package. When the substrate of the present invention is a substrate for a light-emitting element package, the power-feeding pattern formed on a substrate on the side of mounting this can be used, thereby further facilitating the power feeding to the light-emitting element via the metal bumps.

On the other hand, the substrate for mounting a light-emitting element of the present invention is a substrate for mounting a light-emitting element including two or more metal bumps, two or more electrodes provided on the rear surface side of the metal bumps so as to be conductive with the metal bumps, and an insulating layer that exposes the upper surface of the metal bumps, wherein the surfaces of the metal bumps do not have pads.

Since the substrate for mounting a light-emitting element of the present invention has two or more metal bumps, and two or more electrodes provided on the rear surface side of the metal bumps so as to be conductive with the metal bumps, power can be supplied to the light-emitting element via the metal bumps of the obtained substrate even if the surfaces of the metal bumps do not have pads.
Also, the heat generated in the light-emitting element can be efficiently dissipated to the rear surface side via the metal bumps. Therefore, there is no need to perform lamination of a metal foil, plating, or the like for forming the power-feeding pattern as in the prior art, so that costs can be reduced because less amount of source materials is needed, and also the production step will be extremely easy.
As a result of this, a substrate for mounting a light-emitting element such that power can be supplied via a metal bump even if the surfaces of the metal bump do not have pads can be provided by means of a low-cost and easy step that does not involve lamination of a metal foil, plating, or the like.

It is preferable that the upper surface of the metal bumps and the upper surface of the insulating layer are flat. With the substrate for mounting a light-emitting element of the present invention, there is no need to form a power-feeding pattern on the upper surface of the insulating layer, so that the upper surface of the metal bumps and the upper surface of the aforesaid insulating layer can be made flat (coplanar and flat). As a result of this, air can be prevented from remaining in the recess while forming a white resist layer or a light-transmitting resin.

Also, it is preferable that a white resist layer is formed on a surface on the side of mounting the light-emitting element. By forming the white resist layer, the reflectivity of light from the light-emitting element can be enhanced.

The substrate for mounting a light-emitting element of the present invention is preferably a substrate for a light-emitting element package. When the substrate of the present invention is a substrate for a light-emitting element package, the power-feeding pattern formed on an interconnect substrate on the side of mounting this can be used, thereby further facilitating the power feeding to the light-emitting element via the metal bumps.

On the other hand, the substrate for mounting a light-emitting element of the present invention is a light-emitting element package in which a light-emitting element is either thermally or thermally and electrically connected to one of the metal bumps of a substrate for mounting a light-emitting element mentioned above, and the light-emitting element is electrically connected to another one or more of the metal bumps.
With the light-emitting element package of the present invention, the light-emitting element is connected at least thermally to one of the metal bumps, so that the heat generated in the light-emitting element can be efficiently dissipated to the rear surface side via the metal bump.
Also, since the aforesaid light-emitting element is electrically connected to another one or more of the metal bumps, electric power can be supplied to the light-emitting element via the metal bump even if the mounting surface does not have pads.

Alternatively, the substrate for mounting a light-emitting element of the present invention is a light-emitting element package in which a light-emitting element is either thermally or thermally and electrically connected to one of the electrodes of a substrate for mounting a light-emitting element mentioned above, and the light-emitting element is electrically connected to another one or more of the electrodes.
With the light-emitting element package of the present invention, the light-emitting element is connected at least thermally to one of the electrodes, so that the heat generated in the light-emitting element can be efficiently dissipated to the rear surface side via the metal bump that is conductive with the electrode.
Also, since the aforesaid light-emitting element is electrically connected to another one or more of the electrodes, electric power can be supplied to the light-emitting element via the metal bump even if the rear surface does not have pads.

In the above cases, it is preferable that the mounted light-emitting element is sealed with a light-transmitting resin. With the substrate for mounting a light-emitting element of the present invention, there is no need to form a power-feeding pattern on the upper surface of the insulating layer, so that the upper surface of the metal bumps and the upper surface of the aforesaid insulating layer can be made flat (coplanar and flat). Therefore, air can be prevented from remaining in the recess while sealing with a light-transmitting resin.

### BRIEF DESCRIPTION OF THE DRAWINGS

- FIG. 1: is a view showing an example in which one example of a substrate for mounting a light-emitting element of the present invention is used in a light-emitting element package, wherein
- FIG. 1(a): is a vertical cross-sectional view of the whole;
- FIG. 1(b): is a plan view of the substrate for mounting a light-emitting element; and
- FIG. 1(c): is a bottom view of the substrate for mounting a light-emitting element.
- FIG. 2: is a view showing one example of a flow of steps for producing a substrate for mounting a light-emitting element of the present invention.
- FIG. 3: is a cross-sectional view showing one example of the steps for producing a substrate for mounting a light-emitting element of the present invention.
- FIG. 4: is a cross-sectional view showing an example in which another example of a substrate for mounting a light-emitting element of the present invention is used in a light-emitting element package.
- FIG. 5: is a bottom view showing another example of a substrate for mounting a light-emitting element of the present invention.
- FIG. 6: is a bottom view showing another example of a substrate for mounting a light-emitting element of the present invention,

### EMBODIMENTS OF THE INVENTION

Hereafter, the embodiments of the present invention will be described with reference to the drawings.

### Substrate for mounting light-emitting element

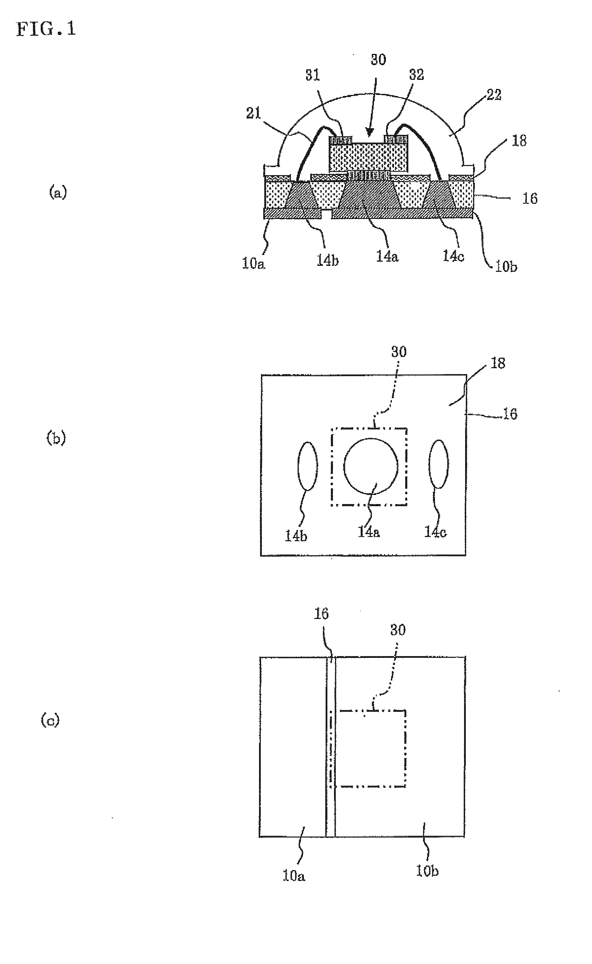

As shown in FIGs. 1(a) to 1(c), a substrate for mounting a light-emitting element of the present invention includes two or more metal bumps 14a to 14c provided on the side of mounting the light-emitting element, two or more electrodes 10a to 10b provided on the rear surface side of the metal bumps 14a to 14c, and an insulating layer 16 that exposes the upper surface of the metal bumps 14a to 14c, and is characterized in that the surfaces of the metal bumps 14a to 14c do not have pads.
Here, the term "do not have pads" refers to a structure in which the upper surface of the metal bumps 14a to 14c is exposed as it is from the insulating layer 16 and does not have pads formed by plating or the like. Specifically, the term refers to a structure that does not have pads for connection of bonding wires, land sections of an interconnect pattern, or the like.

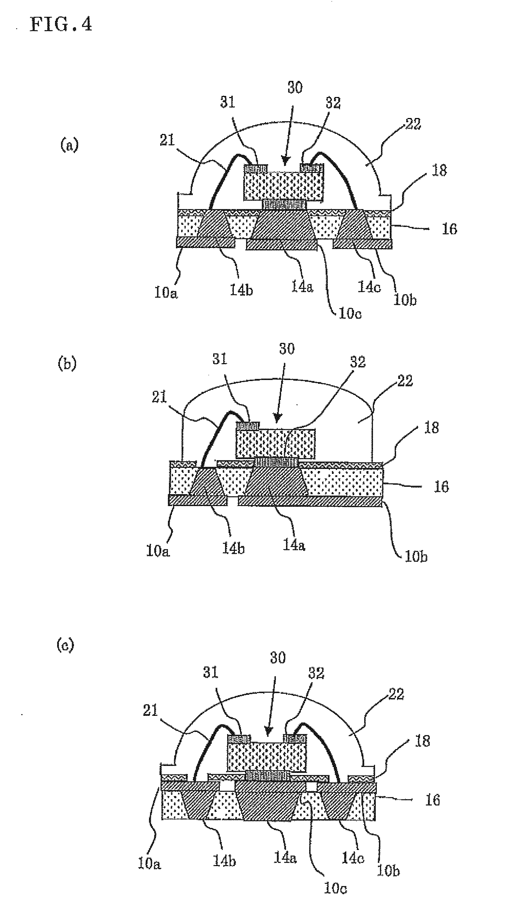

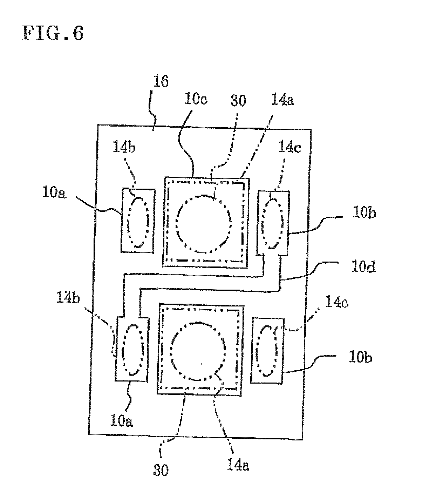

In the present embodiment, an example is shown in which three metal bumps 14a to 14c are provided per each substrate; however, in the present invention, it is sufficient that two or more metal bumps are provided per each substrate (See FIG. 4(b)).
Also, in the case of mounting a plurality of light-emitting elements on one substrate, further more metal bumps may be provided per each substrate (See FIG. 6).

Also, in the present embodiment, an example is shown in which two electrodes 10a to 10b are provided per each substrate; however, in the present invention, it is sufficient that two or more electrodes are provided per each substrate (See FIG. 4(a)).
Also, in the case of mounting a plurality of light-emitting elements on one substrate, further more electrodes may be provided per each substrate, or a structure may be adopted in which the electrodes are connected by a pattern (See FIG. 6).

In the present embodiment, an example is shown in which the upper surface of the metal bumps 14a to 14c and the upper surface of the insulating layer 16 are flat; however, in the present invention, the upper surface of the metal bumps 14a to 14c may be either higher than or lower than the upper surface of the insulating layer 16 (See FIG. 4(a)).

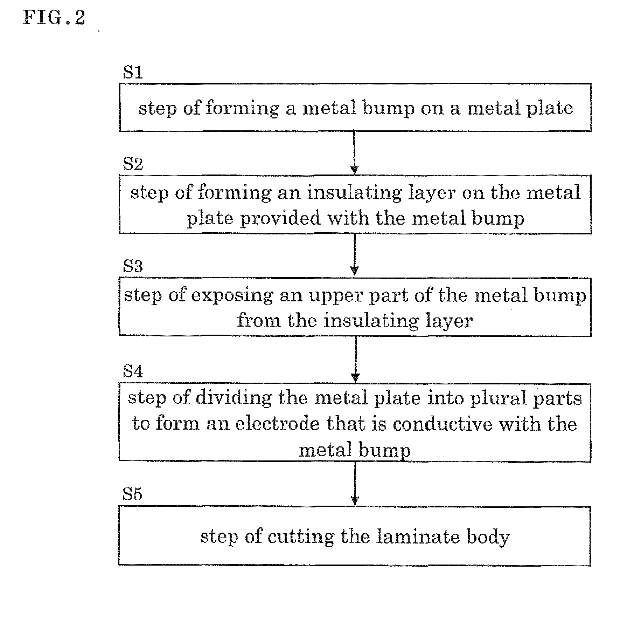

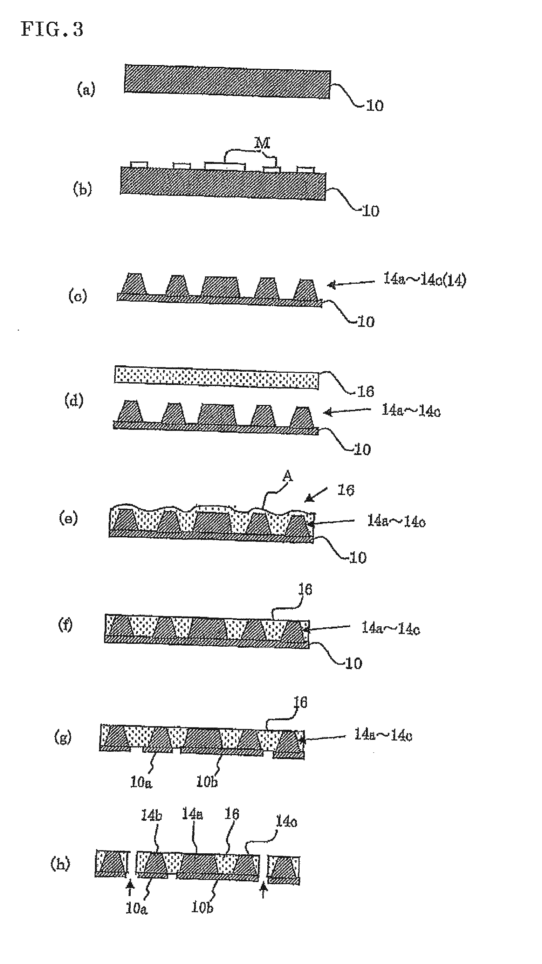

Hereafter, a method for producing a substrate for mounting a light-emitting element of FIG. 1 by the production steps shown in FIGs. 2 and 3 will be described. As shown in FIGs. 2 and 3, the method for producing a substrate for mounting a light-emitting element of the present invention includes: a step of forming an insulating layer 16 on a metal plate 10 provided with a plurality of metal bumps 14 to obtain a laminate body in which an upper surface of the metal bumps 14 is exposed from the insulating layer 16; a step of dividing the metal plate 10 into a plurality of parts to form electrodes 10a, 10b that are conductive with the metal bumps 14; and a step of cutting the obtained laminate body to obtain a plurality of substrates having two or more metal bumps 14. More details are as follows.

(1) Metal bumps 14 are formed on a metal plate 10 (Step S1). As shown in FIGs. 3(a) to 3(c), the metal plate 10 is etched to form the metal bumps 14 for mounting the light-emitting element and for wire connection. In the present embodiment, an example is shown in which a metal plate 10 made of a single layer is used as the metal plate 10.
However, it is possible to use a laminate plate in which a different protective metal layer exhibiting resistance at the time of etching intervenes in the middle of the metal plate 10. By intervention of the protective metal layer, the surface metal layer can be selectively etched. The thickness of the metal plate 10 in the case of a single layer is, for example, 30 µm to 5000 µm.

In the case of using a laminate plate, a laminate plate is used in which a metal plate 10, a protective metal layer, and a surface metal layer for forming metal bumps 14 are laminated. The laminate plate may be produced by any method, and, for example, any of those produced by using electrolytic plating, non-electrolytic plating, sputtering, vapor deposition, or the like and cladding materials can be used.
Regarding the thickness of each layer of the laminate plate, for example, the thickness of the metal plate 10 is 30 µm to 5000 µm; the thickness of the protective metal layer is 1 µm to 20 µm, and the thickness of the surface metal layer is 10 µm to 500 µm.

The metal plate 10 may be either a single layer or a laminate plate. The metal constituting the metal plate 10 may be any metal, and, for example, copper, copper alloy, aluminum, stainless steel, nickel, iron, other alloys, and the like can be used. Among these, copper and aluminum are preferable in view of the heat conductivity and electric conductivity.
By adopting a structure provided with a metal plate 10 exhibiting a good heat dissipation property, the temperature rise of the light-emitting element can be prevented, so that more driving current can be passed and the amount of light emission can be increased. Also, heat conduction to a separately provided heat sink can be improved.

In the case of using a laminate plate, the metal constituting the surface metal layer may be typically copper, copper alloy, nickel, tin, or the like, and in particular, copper is preferable in view of heat conductivity and electric conductivity.

In the case of using a laminate plate, as the metal constituting the protective metal layer, a metal different from the metal plate 10 and the surface metal layer is used, and a different metal exhibiting resistance at the time of etching these metals can be used. Specifically, when these metals are copper, the different metal constituting the protective metal layer may be gold, silver, zinc, palladium, ruthenium, nickel, rhodium, lead-tin-based solder alloy, nickel-gold alloy, or the like.
However, the present invention is not limited to the combination of these metals, and any of the combinations with a different metal exhibiting resistance at the time of etching the aforementioned metals can be used.

Next, as shown in FIG. 3(b), the metal plate 10 is etched with use of an etching resist M to form the metal bumps 14. The size of the metal bumps 14 is designed in view of the size of the light-emitting element to be mounted, the heat conduction efficiency, and the like. For example, in the case of mounting a light-emitting diode chip (bare chip), the width or diameter of the upper surface of the metal bump 14 provided immediately therebelow is preferably 300 µm to 2000 µm.
The upper surface shape of this metal bump 14 may be a circular shape; however, it is preferably a shape that accords to the projected shape of the light-emitting element (for example, a rectangle or a squire).

On the other hand, the upper surface shape of the metal bump 14 for wire connection is preferably an elliptic shape or a rectangular shape in view of reducing the substrate size. Also, the shorter side or shorter diameter of the upper surface of the metal bump 14 for wire connection is preferably 100 µm to 1000 µm.

As the etching resist M, a photosensitive resin, a dry film resist (photoresist), or the like can be used. Here, a mask material for preventing simultaneous etching of the rear surface of the metal plate 10 is preferably provided on the lower surface of the metal plate 10 (not illustrated in the drawings).

A method for etching may be, for example, an etching method using various etching liquids in accordance with the kind of each metal constituting the metal plate 10 or the protective metal layer. For example, when the metal plate 10 is copper and the protective metal layer is the above-described metal (including a metal-based resist), a commercially available alkali etching liquid, ammonium persulfate, hydrogen peroxide/sulfuric acid, or the like can be used. After the etching, the etching resist M is removed.

In the case of using the laminate plate, the protective metal layer that is exposed from the metal bumps 14 must be eventually removed; however, without removing this in advance, the insulating layer 16 may be formed. The protective metal layer can be removed by etching. Specifically, when the metal plate 10 is copper and the protective metal layer is the aforesaid metal, it is preferable to use an acid-based etching liquid such as nitric-acid-based, sulfuric-acid-based, or cyan-based one that is commercially available for peeling-off of solder.

In the case of removing the exposed protective metal layer in advance, the surface of the metal plate 10 will be exposed from the removed part. In order to enhance the adhesion property between this and the insulating layer 16, a surface treatment such as a blackening treatment or a roughening treatment is preferably carried out.

(2) Next, an insulating layer 16 is formed on the metal plate 10 provided with the metal bumps 14 (Step S2). For example, as shown in FIGs. 3(d) to 3(e), the insulating layer 16 can be integrated into the metal plate 10 by heating and pressing with a pressing surface with use of an insulating resin material or the like having a sheet form. Also, after application with a curtain coater or the like using a liquid insulating resin material or the like, this can be cured by heating or the like.

At that time, when the thickness of the insulating resin material is sufficient and the pressing surface is a flat plane, the upper surface will be a flat plane. However, in view of exposing the upper surface of the metal bumps 14 easily later, a bump A is preferably formed at a position corresponding to the metal bumps 14.
For that purpose, it is preferable to dispose at least a sheet material allowing for concave deformation between the pressing surface and the body to be laminated. Also, a pressing surface having a recess at the position corresponding to the metal bumps 14 may be used.
The sheet material allowing for concave deformation undergoes concave deformation at the time of heating and pressing due to the presence of the metal bumps 14, so that a bump A corresponding to that is formed in the laminate body.

As a method for heating and pressing, the heating and pressing may be carried out by using a heating and pressurizing apparatus (heat laminator, heating press) or the like. At that time, the atmosphere may be made to be vacuum (vacuum laminator or the like) in order to avoid mingling of air.
The conditions and the like such as the heating temperature and the pressure may be suitably set in accordance with the material and the thickness of the insulating resin layer forming material and the metal layer forming material; however, the pressure is preferably 0.5 MPa to 30 MPa.

The insulating layer forming material may be any material as long as the material is deformed at the time of lamination and solidified by heating or the like and has a heat resistance that is required in an interconnect substrate.
Specifically, various reaction-curing resins such as a polyimide resin, a phenolic resin, and an epoxy resin, a composite (prepreg) of that with glass fibers, ceramic fibers, aramide fibers, or the like can be exemplified.

Also, the insulating layer 16 is preferably constituted of a material having a high heat conductivity and, for example, a resin or the like containing a thermally conductive filler may be exemplified.
The insulating layer 16 in this case has a heat conductivity of 1.0 W/mK or more, preferably has a heat conductivity of 1.2 W/mK or more, and more preferably has a heat conductivity of 1.5 W/mK or more. By this, the heat from the metal bumps 14 can be dissipated efficiently to the metal plate 10 side.
Here, the heat conductivity of the insulating resin layer 16 is suitably determined by selecting a blend in consideration of the blending amount and the particle size distribution of the thermally conductive filler; however, in consideration of the applicability of the insulative adhesive agent before curing, generally about 10 W/mK is preferable as the upper limit.

The sheet material may be a material that allows for concave deformation at the time of heating and pressing, and cushion paper, rubber sheet, elastomer sheet, non-woven cloth, woven cloth, porous sheet, foamed body sheet, metal foil, a composite of these, and the like may be raised as examples.
In particular, an elastically deformable one such as cushion paper, rubber sheet, elastomer sheet, foamed body sheet, or a composite of these is preferable.

(3) The metal bumps 14 are exposed from the insulating layer 16 (Step S3). As shown in FIG. 3(f), the metal bumps 14 are exposed from the insulating layer 16 by removal of the bump A or the like, thereby obtaining a laminate body in which the whole of the upper surface is flat.
At the time of this removal of the bump A, it is preferable to flatten the surface by removing the bump A so that the height of the insulating layer 16 and the height of the metal bumps 14 will be equal. A state is brought about in which the insulating resin layer 16 is formed around the metal bumps 14.

As a method of removing the bump A, a method by grinding or polishing is preferable, and a method of using a grinding apparatus having a hard rotary blade in which a plurality of hard blades made of diamond or the like are disposed and arranged in the radial direction of a rotary plate, a method of using a sander, a belt sander, a grinder, a plane grinding machine, a hard abrasive grain molded article, and the like may be raised as examples.
When a grinding apparatus is used, the upper surface can be flattened by moving the hard rotary blade along the upper surface of the fixed and supported interconnect substrate while rotating the hard rotary blade.
Also, as a method of polishing, a method of light polishing with use of a belt sander, buff polishing, or the like may be raised as an example. When the bump A is formed in the laminate body as in the present invention, it will be easy to grind that part alone, so that the flattening of the whole can be carried out with more certainty.

(4) The metal plate 10 is divided into a plurality of parts to form electrodes 10a to 10b that are conductive with the metal bumps 14a to 14c (Step S4). In the present embodiment, an example is shown in which the metal bumps 14a and 14c are conductive with the electrode 10b; however, an electrode and a pad that are respectively conductive with the metal bumps 14a and 14c may be provided.

In the present embodiment, an example is shown in which the metal plate 10 is divided into a plurality of parts by etching, as shown in FIG. 3(g).
At that time, it is preferable to remove the metal plate 10 of the part that will be cut in the subsequent step in advance by etching, in view of extending the lifetime of the cutting blade and preventing the generation of burrs.

At the time of etching, an etching liquid or a mask such as described above is used. At this time, a mask material for preventing simultaneous etching of the metal bumps 14 is preferably provided on the upper surface (illustration is omitted).

In order to increase the reflection efficiency, plating with use of a noble metal such as gold, nickel, or silver is carried out on the surface of the metal bumps 14a to 14c and the electrodes 10a to 10b. Also, in the same manner as in a conventional interconnect substrate, a solder resist may be formed on the light-emitting element mounting side or on the rear side, or solder plating may be carried out partially.
In particular, it is preferable that a white resist layer 18 is formed on a surface on the light-emitting element mounting side in order to increase the reflection efficiency.

(5) The laminate body is cut to obtain a plurality of substrates having two or more metal bumps 14a to 14c (Step S5). In FIG. 3(h), the cutting position is shown by an arrow symbol. For the cutting, various cutting devices such as a dicer, a router, a laser, and the like can be used.
By this, a substrate for mounting a light-emitting element including two or more metal bumps 14a to 14c, two or more electrodes 10a to 10b provided on the rear surface side of the metal bumps 14a to 14c so as to be conductive with the metal bumps 14a to 14c, and an insulating layer 16 that exposes the upper surface of the metal bumps wherein the surfaces of the metal bumps do not have pads can be produced, as shown in FIGs. 1(a) to 1(c).

In this substrate for mounting a light-emitting element, the light-emitting element may be mounted on the surface of the metal bump side, or the surface of the electrode side.

### Light-emitting element package

In the present invention, a light-emitting element 30 is bonded (allowed to adhere or the like) to the upper surface of the metal bump 14a, the electrode 10b, or the pad 10c as shown in FIG. 1. A method of bonding may be any of an electrically conductive paste, a thermally conductive sheet, a thermally conductive adhesive agent, a two-sided tape, joining with solder such as a solder, and the like; however, joining with use of a metal is preferable in view of a heat dissipation property.

The light-emitting element 30 may be, for example, a light-emitting diode chip (bare chip), a semiconductor laser chip, or the like. For the light-emitting element 30, there are a type such that two electrodes are present on the light-emitting side and a type such that only one of the electrodes is present, and the rear surface thereof can be classified into two kinds of a cathode type and an anode type. In the present invention, any of these can be used.

The light-emitting element 30 is electrically connected to the upper surface of the metal bumps 14b, 14c or the electrodes 10a, 10b, This electrically conductive connection may be established by connecting the upper electrodes 31, 32 of the light-emitting element with each of the electrodes 10a, 10b by wire bonding or the like using a metal fine wire 21. For the wire bonding, a supersonic wave or a combination of this with heating, or the like can be used. Also, as another embodiment, it can be constructed in such a manner that an electrically conductive connection is established between the lower-side electrodes of the light-emitting element 30 and the electrodes 10a, 10b without using a metal fine wire.

Also, a reflector may be formed around the metal bumps 14, and a structure having a reflector function may be formed by molding the insulating layer 16 in a three-dimensional manner. Also, the inside of the dam may be covered with a transparent resin or the like, and further a transparent resin lens having a convex surface may be provided thereabove. The transparent resin or the transparent resin lens may be allowed to contain a fluorescent agent. A preferable mode is such that the mounted light-emitting element 30 is sealed with a light-transmitting resin 22.

A method of sealing with the light-transmitting resin 22 may be any of a method of molding using a mold, injection molding by insertion of the substrate, a method by printing or using a squeegee, a method using a dispenser, and the like.

A light-emitting element package generally has a package construction such that one light-emitting element 30 is mounted on a substrate; however, in the present invention, one using a substrate constructed in such a manner that a plurality of light-emitting elements 30 can be mounted is also referred to as a light-emitting element package.

### Other Embodiments

(1) In the above-described embodiment, an example has been shown in which the upper surface of the metal bumps and the upper surface of the aforethe insulating layer are flat; however, in the present invention, the upper surface of the metal bumps 14 can be positioned to be higher than the upper surface of the insulating layer 16 as shown in FIG. 4(a).
In that case, in view of flattening the surface, it is preferable to allow the upper surface of the metal bumps 14 to have the same height as the upper surface of the white resist layer 18 by adjusting the thickness of the white resist layer 18.

Here, in the example shown in FIG. 4(a), the pad 10c is provided to the metal bump 14a; the electrode 10a is provided to the metal bump 14b; and the electrode 10b is provided to the metal bump 14c. By this, the pad 10c can be used only for heat dissipation.

(2) In the above-described embodiment, an example has been shown in which three metal bumps are provided; however, in the present invention, it may be sufficient that only two metal bumps 14a to 14b are provided as shown in FIG. 4(b). In that case, one metal bump 14a plays a role of connecting the light-emitting element 30 thermally and electrically, and the other metal bump 14b plays a role of connecting the light-emitting element 30 electrically.
The light-emitting element package using this substrate will be one in which the light-emitting element 30 is thermally and electrically connected to one metal bump 14a of the substrate for mounting the light-emitting element, and the light-emitting element 30 is electrically connected to other metal bump 14b.

In the embodiment shown in FIG. 4(b), an example has been shown in which the rear surface of the light-emitting element 30 has an electrode 32; however, a light-emitting element 30 of a two-wire system can be mounted even on a substrate provided with only two metal bumps 14a to 14b by allowing the upper surface of the metal bump 14a of the illustrated example to be larger than the projection surface of the light-emitting element 30.

Here, in the illustrated embodiment, an example is shown in which the sealing with a light-transmitting resin 22 is carried out by a squeegee. In the case of forming a lens by the squeegee, the lens shape can be adjusted in accordance with the viscosity or the like of the resin that is put to use.

(3) In the above-described embodiment, an example has been shown in which the light-emitting element is mounted on the metal bump side; however, in the present invention, the light-emitting element 30 may be mounted on the electrode side as shown in FIG. 4(c).
In that case, it will be a light-emitting element package in which the light-emitting element 30 is either thermally or thermally and electrically connected to one pad (or electrode) 10c of the substrate for mounting the light-emitting element, and the light-emitting element 30 is electrically connected to other electrodes 10a, 10b.

(4) In the above-described embodiment, an example has been shown in which the insulating layer is formed with resin; however, the material for forming the insulating layer in the present invention may be any material as long as it is an insulating material, and a resin that is not usually used as a substrate material, for example, a silicone resin or the like, ceramics other than resins, glass, inorganic salts, and the like can also be used.
In the case of ceramics, for example, an insulating layer integrated with a metal plate can be formed by baking or sintering after a slurry containing fine particles of ceramics or source material particles is applied onto the metal plate.
Also, in order to enhance the reflection efficiency of the insulating layer itself, resin containing a white pigment or the like can be used as the insulating layer. In that case, the resin is preferably used without providing a solder resit.

(5) In the above-described embodiment, an example has been shown in which the step of dividing the metal plate into a plurality of parts is carried out by etching; however, in the present invention, the metal plate 10 may be divided into a plurality of parts by groove processing using a cutting blade or the like.
For example, as shown in FIG. 1(c), in the case in which the metal plate 10 is divided into an electrode 10a and an electrode 10b by a straight line, the metal plate 10 can be divided into a plurality of parts by forming a groove having a straight line form.

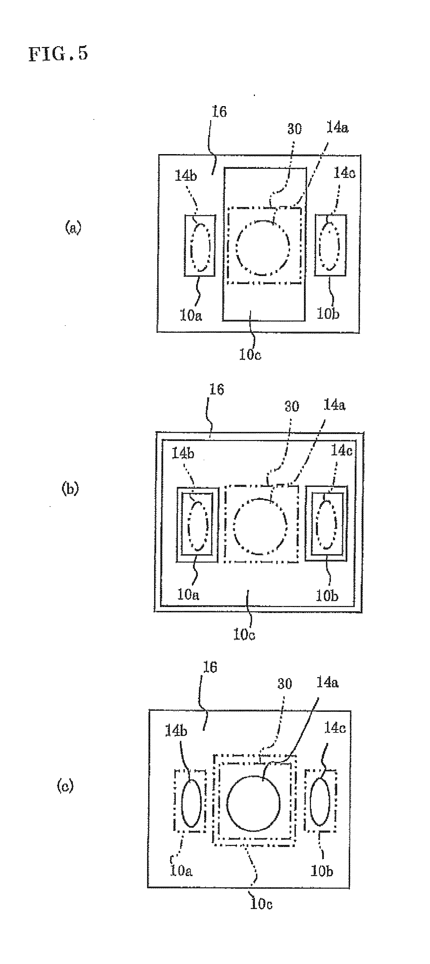

(6) In the above-described embodiment, an example has been shown in which the electrodes are formed by dividing the metal plate along a straight line by etching; however, in the present invention, the pattern of the electrode side surfaces may be further more complex as shown in FIGs. 5(a) to 5(c).

In the example shown in FIG. 5(a), the electrodes 10a, 10b for electrical connection are formed to be comparatively small, and the pad 10c for thermal connection is formed to be large. In this manner, in the case of a structure in which the metal plate 10 does not remain around the substrate, the cutting blade can be made to have a long lifetime in cutting the laminate body, and also problems such as generation of burrs can be made less liable to occur.

In the example shown in FIG, 5(b), further the pad 10c for thermal connection is formed to be larger. By this, the heat dissipation from the light-emitting element 30 can be improved.

In the example shown in FIG. 5(c), the metal bumps 14a to 14c exposed from the insulating layer 16 are present on the rear surface side in order to mount the light-emitting element 30 on the electrode side.
In this case, as the shape of the upper surface of the metal bumps 14a to 14c, a shape suitable for solder connection is selected. The shape thereof may be, for example, a circular shape, an elliptic shape, a quadrilateral shape, or the like.

(7) In the above-described embodiment, an example has been shown in which one light-emitting element is mounted on one substrate; however, in the present invention, as shown in FIG. 6, a plurality of light-emitting elements 30 may be mounted on one substrate. In that case, the electrodes 10a, 10b may all be made independent; however, it is preferable to connect the electrodes electrically with each other via a connection pattern 10d. As a connection mode, any of a series connection, a parallel connection, and a combination thereof may be used.

(8) In the above-described embodiment, an example has been shown in which the bump is removed after the bump is formed above the metal bumps while forming the insulating layer; however, in the present invention, the metal bumps may be exposed by removing the whole surface by sand blast or the like after the insulating layer is formed to be flat.

### DESCRIPTION OF PREFERENCE SIGNS

- 10: metal plate
- 10a, 10b: electrode (pad)
- 10c: pad (electrode)
- 14a to 14c: metal bump
- 16: insulating layer
- 18: white solder resist
- 22: light-transmitting resin
- 30: light-emitting element
- A: bump

## Claims

1. A method for producing a substrate for mounting a light-emitting element, comprising:
- a step of forming an insulating layer on a metal plate provided with a plurality of metal bumps to obtain a laminate body in which an upper surface of the metal bumps is exposed from the insulating layer;
- a step of dividing the metal plate into a plurality of parts to form electrodes that are conductive with the metal bumps; and
- a step of cutting the obtained laminate body to obtain a plurality of substrates having two or more metal bumps.

2. The method for producing a substrate for mounting a light-emitting element according to claim 1,
wherein the step of dividing the metal plate into a plurality of parts is carried out by etching.

3. The method for producing a substrate for mounting a light-emitting element according to claim 1,
wherein the substrate for mounting a light-emitting element is a substrate for a light-emitting element package.

4. A substrate for mounting a light-emitting element comprising two or more metal bumps, two or more electrodes provided on the rear surface side of the metal bumps so as to be conductive with the metal bumps, and an insulating layer that exposes the upper surface of the metal bumps, wherein the surfaces of the metal bumps do not have pads.

5. The substrate for mounting a light-emitting element according to claim 4, wherein the upper surface of the metal bumps and the upper surface of the insulating layer are flat.

6. The substrate for mounting a light-emitting element according to claim 4, wherein a white resist layer is formed on a surface on the side of mounting the light-emitting element.

7. The substrate according to claim 4,
which is a substrate for a light-emitting element package.

8. A light-emitting element package in which a light-emitting element is either thermally or thermally and electrically connected to one of the metal bumps of a substrate for mounting a light-emitting element according to claim 4 or 5,
and the light-emitting element is electrically connected to another one or more of the metal bumps.

9. A light-emitting element package in which a light-emitting element is either thermally or thermally and electrically connected to one of the electrodes of a substrate for mounting a light-emitting element according to claim 4 or 5,
and the light-emitting element is electrically connected to another one or more of the electrodes.

10. The light-emitting element package according to claim 8,
wherein the mounted light-emitting element is sealed with a light-transmitting resin.

11. The light-emitting element package according to claim 9,
wherein the mounted light-emitting element is sealed with a light-transmitting resin.

## Amended claims

### Amended claims under Art. 19.1 PCT

**1.** A method for producing a substrate for mounting a light-emitting element, comprising:
- a step of forming an insulating layer on a metal
plate provided with a plurality of metal bumps to
obtain a laminate body in which an upper surface of the metal bumps is exposed from the insulating layer;
- a step of dividing the metal plate into a plurality of parts to form electrodes that are conductive with the metal bumps; and
- a step of cutting the obtained laminate body to obtain a plurality of substrates having two or more metal bumps,

**2.** The method according to claim 1,
wherein the step of dividing the metal plate into a plurality of parts is carried out by etching.

**3.** The method according to claim 1 or 2,
wherein the substrate for mounting a light-emitting element is a substrate for a light-emitting element package.

**4.** (Canceled)

**5.** (Canceled)

**6.** (Canceled)

**7.** (Canceled)

**8.** (Canceled)

**9.** (Canceled)

**10.** (Canceled)

**11.** (Canceled)
